# EUROPÄISCHE PATENTSCHRIFT

(11) **EP 2 799 983 B1**
(45) Veröffentlichungstag und Bekanntmachung des Hinweises auf die Patenterteilung: **04.04.2018**
(21) Anmeldenummer: 14151561.9
(22) Anmeldetag: 17.01.2014
(51) Int. Cl.: G06F 9/44, G06F 15/78, G06F 17/50, G06F 8/35, G06F 9/455

(54) **Flexible Aufteilung der I/O Kanäle einer Hardware Komponente**
Flexible distribution of I/O channels of a hardware component
Répartition flexible des canaux E/S d'un composant matériel

(30) Priorität: 29.04.2013 DE 102013104320
(43) Veröffentlichungstag der Anmeldung: 05.11.2014
(73) Patentinhaber: dSPACE digital signal processing and control engineering GmbH, 33102 Paderborn (DE)
(72) Erfinder: Merten, Stefan, 33605 Bielefeld (DE); Schlenger, Marc, 33104 Paderborn (DE); Ross, Holger, 48165 Münster-Hiltrup (DE); Mertens, Frank, 33175 Bad Lippspringe (DE)

(56) Entgegenhaltungen:
- RAMONA DUELKS ET AL: "A Real-Time Test and Simulation Environment Based on Standard FPGA Hardware", TESTING: ACADEMIC AND INDUSTRIAL CONFERENCE - PRACTICE AND RESEARCH TECHNIQUES, 2009. TAIC PART '09, IEEE, PISCATAWAY, NJ, USA, 4. September 2009 (2009-09-04), Seiten 197-204, XP031611115, ISBN: 978-0-7695-3820-4
- "Auf zu schnelleren Zeiten", , 1. Juni 2012 (2012-06-01), XP055124881, Gefunden im Internet: URL:http://www.dspace.com/shared/data/pdf/ 2012/Magazin_42_45_Schnelle_Zeiten_D.pdf [gefunden am 2014-06-24]
- "Wenn sich Prozessor und FPGA ergänzen", , 1. Mai 2011 (2011-05-01), XP055124886, Gefunden im Internet: URL:http://www.dspace.com/shared/data/pdf/ 2011/503_dSpace_Ek_auto_2011-05_lowres_pdf .pdf [gefunden am 2014-06-24]
- JÜRGEN TEICH ET AL: "Optimization of Dynamic Hardware Reconfigurations", THE JOURNAL OF SUPERCOMPUTING, KLUWER ACADEMIC PUBLISHERS, BO, Bd. 19, Nr. 1, 1. Mai 2001 (2001-05-01), Seiten 57-75, XP019215663, ISSN: 1573-0484, DOI: 10.1023/A:1011188411132
- "AT6000 Series Configuration", , 1. Januar 1999 (1999-01-01), XP055124925, Gefunden im Internet: URL:http://www.zmitac.aei.polsl.pl/Electro nics_Firm_Docs/ATMEL/Atmel/acrobat/doc0436 .pdf [gefunden am 2014-06-24]

## Beschreibung

Die vorliegende Erfindung betrifft ein Verfahren zum Erstellen einer Software für eine Hardware-Komponente eines Mess-, Steuer- oder Regelsystems mit einem Prozessor, einem FPGA und einer Mehrzahl von I/O-Kanälen, wobei die I/O-Kanäle an das FPGA angeschlossen sind und das FPGA über ein Kommunikations-Interface mit dem Prozessor verbunden ist.

Ebenfalls betrifft die Erfindung ein Computerprogrammprodukt mit Computer-implementierten Anweisungen, das nach dem Laden und Ausführen in einer geeigneten Datenverarbeitungseinrichtung die Schritte des obigen Verfahrens ausführt sowie ein Digitales Speichermedium mit elektronisch auslesbaren Steuersignalen, die so mit einer programmierbaren Datenverarbeitungseinrichtung zusammenwirken können, dass das obige Verfahren auf der Datenverarbeitungseinrichtung ausgeführt wird. Weiterhin betrifft die Erfindung ein Verfahren zum Betreiben einer solchen Hardwarekomponente sowie eine Hardwarekomponente zur Durchführung des Verfahrens.

Die Echtzeitsimulation von komplexen, dynamischen Modellen stellt aufgrund der engen zeitlichen Randbedingungen selbst an moderne Rechenknoten hohe Anforderungen. Beispielsweise werden solche Modelle in automotiven Hardware-in-the-Loop-Simulationen (HiL) eingesetzt, wo schnelle Regelkreise geschlossen werden müssen. Dies ist etwa bei der Simulation von Zylinderinnendrucksensoren der Fall, die bei der Verbrauchs- oder Abgasreduktion eine zunehmend größere Rolle spielen. Aber auch bei Regelstrecken die eine hohe Dynamik aufweisen, wie zum Beispiel bei Elektromotoren, sind kurze Zykluszeiten und geringe Latenzen unabdingbar.

Diese können mit CPU-basierten Simulationen praktisch kaum mehr umgesetzt werden.

Field Programmable Gate Arrays (FPGAs) können Hardware-Komponenten bei der Echtzeitsimulation unterstützen, indem sie die Berechnung von dynamischen Teilen eines Modells übernehmen. Durch die hohe Flexibilität und Möglichkeit der Parallelverarbeitung von Signalen lassen sich durch den Einsatz von FPGAs auch harte Echtzeitanforderungen leicht erfüllen. Die FPGAs können allgemein als Hardwarebeschleuniger für CPUs dienen.

Die beschriebenen Hardware-Komponenten werden im Stand der Technik in zwei Betriebsarten verwendet. In einer ersten Betriebsart wird auf das FPGA eine fixe Funktionalität geladen, wodurch das FPGA konfiguriert wird. Über diese fixe Funktionalität werden die I/O-Kanäle mit einem festen Funktionsumfang an dem Kommunikations-Interface bereitgestellt, so dass die I/O-Kanäle in einer Applikation auf dem Prozessor verwendet werden können. Ein Anwender arbeitet in dieser ersten Betriebsart ausschließlich mit einer modellbasiert erstellten Prozessor-Applikation, z.B. mit einem RTI Blockset. Die Applikation läuft komplett auf dem Prozessor und greift über die fixe FPGA Funktionalität auf die I/O zu.

In einer zweiten Betriebsart wird ein vom Anwender modellbasiert erstellter FPGA Code auf das FPGA geladen, der die I/O-Kanäle in dem FPGA verwendet. Hierbei handelt es sich beispielsweise um ein Regelmodell auf dem FPGA oder um eine Vorverarbeitung der I/O-Kanäle in dem FPGA. Der Prozessor greift in dieser Betriebsart nicht auf die I/O-Kanäle zu. Der Anwender arbeitet in dieser Betriebsart mit einer modellbasiert erstellten FPGA Applikation, z.B. mit dem RTI FPGA Programming Blockset. Auf dem Prozessor kann zusätzlich eine Prozessor-Applikation ausgeführt werden, die mit der FPGA-Applikation kommunizieren kann. Allerdings kann die Prozessor Applikation die I/O -Kanäle nicht mit einem festen Funktionsumfang und einer definierten Schnittstelle verwenden.

Aus RAMONA DUELKS ET AL: "A Real-Time Test and Simulation Environment Based on Standard FPGA Hardware", ist zeitkritische Signale auf einem FPGA zu analysieren und andere Signale an einen PC weiter zu leiten.

Aus "Auf zu schnelleren Zeiten", Gefunden im Internet: URL:http://www.dspace.com/shared/data/pdf/2012/Magazin_42_4 5_Schnelle_Zeiten_D.pdf [gefunden am 2014-06-24] ist die freie Programmierung von FPGAs mit einer Modellbibliothek bekannt.

Aus "Wenn sich Prozessor und FPGA ergänzen", Gefunden im Internet:
URL:http://www.dspace.com/shared/data/pdf/2011/503_dSpace_E k_auto_2011-05_lowres_pdf.pdf [gefunden am 2014-06-24] ist die modellbasierte Programmierung von FPGAs bekannt.

Ausgehend von dem oben genannten Stand der Technik liegt der Erfindung somit die Aufgabe zugrunde, ein Verfahren der oben genannten Art anzugeben, welches eine flexible Verwendung der Hardwarekomponente ermöglicht, wobei FPGA und Prozessor während der Ausführung mit I/O-Kanälen kommunizieren können und die verfügbaren I/O-Kanäle der Hardware-Komponente frei auf FPGA und Prozessor aufgeteilt werden können.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Erfindungsgemäß ist somit ein Verfahren zum Erstellen einer Software für eine Hardware-Komponente eines Mess-, Steuer- oder Regelsystems mit einem Prozessor, einem FPGA und einer Mehrzahl von I/O-Kanälen, wobei die I/O-Kanäle an das FPGA angeschlossen sind und das FPGA über ein Kommunikations-Interface mit dem Prozessor verbunden ist, angegeben, umfassend die Schritte Auswahl einer ersten Teilmenge der I/O-Kanäle zur Bedienung durch das FPGA, Erstellen einer ersten Applikation zur Ausführung auf dem FPGA, Auswahl einer zweiten Teilmenge der I/O-Kanäle zur Bedienung durch den Prozessor, Erstellen einer zweiten Applikation zur Ausführung auf dem Prozessor, wobei der Schritt des Erstellens einer ersten Applikation das Erstellen von Code zum Verbinden der zweiten Teilmenge der I/O-Kanäle mit dem Kommunikations-Interface umfasst.

Grundidee der vorliegenden Erfindung ist es also, zwei Applikationen zu erstellen, eine auf dem Prozessor und eine auf dem FPGA, die je nach Anwendung die I/O-Kanäle beliebig auf die beiden Applikationen aufteilen. Die erste Applikation auf dem FPGA, im Weiteren auch FPGA-Applikation genannt, greift somit nur auf die I/O-Kanäle zu, welche sie für die Ausführung ihrer Aufgaben benötigt. Die übrigen I/O-Kanäle werden über das Kommunikations-Interface in der zweiten Applikation in dem Prozessor, im Weiteren auch Prozessor-Applikation, bereitgestellt. Dies ermöglicht eine Kombination einer klassischen modellbasierten Erstellung von Steuer-, Mess- oder Regelmodellen mit modellbasiert erstellten FPGA Modellen, die auf Grund der FPGA Technologie geringe Zykluszeiten im Sub-Mikrosekunden Bereich für Regelmodelle oder sehr leistungsstarke Signalvorverarbeitung für Mess-Anwendungen auf einer Hardware-Komponente ermöglichen.

Bei dem Verfahren können die erste und die zweite Teilmenge jeweils bedarfsgerecht ausgewählt werden. Alternativ kann auch eine implizite Auswahl der ersten oder zweiten Teilmenge erfolgen, indem lediglich die erste oder zweite Teilmenge ausgewählt wird und die jeweils andere Teilmenge die Menge der verbleibenden I/O-Kanäle bildet.

Die Auswahl der I/O-Kanäle zu der ersten oder zweiten Teilmenge kann prinzipiell zu einem beliebigen Zeitpunkt erfolgen. Beispielweise kann initial sowohl die erste wie auch die zweite Teilmenge der I/O-Kanäle ausgewählt werden, und das Erstellen der ersten und zweiten Applikation erfolgt im Anschluss daran. Auch kann die Auswahl der I/O-Kanäle zu der ersten oder zweiten Teilmenge vor dem eigentlichen Erstellen der entsprechenden ersten oder zweiten Applikation erfolgen, oder ein Teilschritt des jeweiligen Schritts zum Erstellen der ersten oder zweiten Applikation sein. Auch die Abfolge der Erstellung der ersten und zweiten Applikation ist prinzipiell beliebig. Die I/O-Kanäle können entweder analoge oder digitale I/O-Kanäle sein.

In vorteilhafter Ausgestaltung der Erfindung umfasst der Schritt des Erstellens von Code zum Verbinden der zweiten Teilmenge der I/O-Kanäle mit dem Kommunikations-Interface das Erstellen von Code zum Durchführen einer Signalverarbeitung zwischen wenigstens einem der I/O-Kanäle der zweiten Teilmenge und dem Kommunikations-Interface. Entsprechend kann beispielsweise eine Vorverarbeitung von an einem I/O-Kanal empfangen Eingangswerten durch eine schnelle Verarbeitung auf dem FPGA durchgeführt werden, während weitere Auswertungsschritte flexibel auf dem Prozessor durchgeführt werden.

Erfindungsgemäß umfasst das Verfahren das Erstellen eines Applikationsmodells, wobei der Schritt des Erstellens der ersten Applikation das modellbasierte automatische Erstellen von Code umfasst. Die Modellierung ermöglicht eine einfache Codeerzeugung, wodurch kurze Entwicklungszyklen möglich sind. Vorzugsweise werden Funktionsblöcke verwendet, um eine gewünschte Funktionalität im FPGA modellbasiert in Matlab oder Simulink zu erstellen. Weiter bevorzugt werden benötigte I/O-Kanäle in das Applikationsmodell gezogen und mit einer zuvor erstellten Funktionalität verbunden.

Erfindungsgemäß umfasst der Schritt des Erstellens von Code zum Verbinden der zweiten Teilmenge der I/O-Kanäle mit dem Kommunikations-Interface das automatische Erstellen von Code zum Verbinden von I/O-Kanälen, die Teil der zweiten Teilmenge von I/O-Kanälen sind. Somit kann ein Anwender I/O-Kanäle der zweiten Teilmenge bei der Modellierung der FPGA-Applikation unbeachtet lassen, wodurch diese automatisch, beispielsweise gemäß einer Voreinstellung, mit dem Kommunikations-Interface verbunden werden.

In vorteilhafter Ausgestaltung der Erfindung umfasst der Schritt des Erstellens von Code zum Verbinden der zweiten Teilmenge der I/O-Kanäle mit dem Kommunikations-Interface das Bereitstellen von vorsynthetisiertem Code zum Verbinden von I/O-Kanälen, die Teil der zweiten Teilmenge von I/O-Kanälen sind. Der vorsynthetisierte Code ermöglicht es darüber hinaus, Zeiten für die Erzeugung der ersten Applikation zu reduzieren. Der vorsynthetisierte Code wird Teil der FPGA-Applikation, ohne dass dieser übersetzt werden muss. Der vorsynthetisierte Code kann mit anderen Code Bestandteilen einfach zusammengefügt werden, was bei den verschiedenen Anbietern von FPGAs als Fitting oder Place&Route bezeichnet wird. Anschließend kann der Code in seiner Gesamtheit auf das FPGA geladen werden. Der vorsynthetisierte Code wird vorzugsweise aus einer vorhandenen Bibliothek entnommen.

Erfindungsgemäß umfasst der Schritt des Erstellens der ersten Applikation das Bereitstellen von Identifikationsinformationen der ersten Teilmenge. Die Identifikationsinformationen der ersten Teilmenge können verwendet werden, um bei der Erstellung der zweiten Applikation die Auswahl der I/O-Kanäle auf die noch verfügbaren Kanäle zu beschränken, was die Erstellung der zweiten Applikation einfach und zuverlässig ermöglicht. Vorzugsweise stellt eine Modellierungsumgebung für die modelbasierte FPGA Applikationserstellung alle I/O-Kanäle der Hardware-Komponente für das Applikationsmodell bereit. Nach der Modellierung der FPGA-Applikation werden für die nicht in der FPGA-Applikation benötigten I/O-Kanäle Identifikationsinformationen bereitgestellt für die zweite Applikation, damit diese die freien, nicht in der FPGA-Applikation benötigten I/O-Kanäle gezielt verwenden kann.

In vorteilhafter Ausgestaltung der Erfindung umfasst der Schritt des Erstellens der ersten Applikation das Empfangen von Identifikationsinformationen der zweiten Teilmenge. Die Identifikationsinformationen der zweiten Teilmenge können verwendet werden, um bei der Erstellung der ersten Applikation die Auswahl der I/O-Kanäle auf die noch verfügbaren Kanäle zu beschränken, was die Erstellung der ersten Applikation einfach und zuverlässig ermöglicht. Für die nicht in der zweiten Applikation benötigten I/O-Kanäle können Identifikationsinformationen bereitgestellt werden für die erste Applikation, damit diese freie, nicht in der Prozessor-Applikation benötigten I/O-Kanäle gezielt verwenden kann.

Erfindungsgemäß umfasst das Verfahren zusätzlich den Schritt Erstellen eines Applikationsmodells, wobei der Schritt des Erstellens der zweiten Applikation das modellbasierte automatische Erstellen von Code umfasst. Die Modellierung ermöglicht eine einfache Codeerzeugung, wodurch kurze Entwicklungszyklen möglich sind. Vorzugsweise werden Funktionsblöcke verwendet, um eine gewünschte Funktionalität im Prozessor modellbasiert in Matlab oder Simulink zu erstellen. Weiter bevorzugt werden benötigte I/O-Kanäle in das Applikationsmodell gezogen und mit einer zuvor erstellten Funktionalität verbunden.

Vorzugsweise ist das Applikationsmodell ein einheitliches Modell zum Erstellen der ersten und zweiten Applikation. Alternativ kann jedoch auch ein Modell zum Erstellen der ersten Applikation und ein weiteres Modell zum Erstellen der zweiten Applikation verwendet werden.

In vorteilhafter Ausgestaltung der Erfindung umfasst der Schritt des Erstellens der zweiten Applikation das Bereitstellen von Identifikationsinformationen der zweiten Teilmenge. Die Identifikationsinformationen der zweiten Teilmenge können verwendet werden, um bei der Erstellung der ersten Applikation die Auswahl der I/O-Kanäle auf die noch verfügbaren Kanäle zu beschränken, was die Erstellung der ersten Applikation einfach und zuverlässig ermöglicht. Vorzugsweise stellt eine Modellierungsumgebung für die modelbasierte Prozessor Applikationserstellung alle I/O-Kanäle der Hardware-Komponente für das Applikationsmodell bereit. Nach der Modellierung der Prozessor-Applikation werden für die nicht in der Prozessor-Applikation benötigten I/O-Kanäle die Identifikationsinformationen für die erste Applikation bereitgestellt, damit diese die freien, nicht in der Prozessor-Applikation benötigten I/O-Kanäle gezielt verwenden kann.

Erfindungsgemäß umfasst der Schritt des Erstellens der zweiten Applikation das Empfangen von Identifikationsinformationen der ersten Teilmenge. Die Identifikationsinformationen der ersten Teilmenge können verwendet werden, um bei der Erstellung der zweiten Applikation die Auswahl der I/O-Kanäle auf die noch verfügbaren Kanäle zu beschränken, was die Erstellung der zweiten Applikation einfach und zuverlässig ermöglicht. Für die nicht in der ersten Applikation benötigten I/O-Kanäle können Identifikationsinformationen bereitgestellt werden für die zweite Applikation, damit diese die freien, nicht in der FPGA-Applikation benötigten I/O-Kanäle gezielt verwenden kann.

Weiterhin betrifft die Erfindung ein Verfahren zum Betreiben einer Hardware-Komponente eines Mess-, Steuer- oder Regelsystems mit einem Prozessor, einem FPGA und einer Mehrzahl von I/O-Kanälen, wobei die I/O-Kanäle an das FPGA angeschlossen sind und das FPGA über ein Kommunikations-Interface mit dem Prozessor verbunden ist, umfassend das Laden einer nach dem obigen Verfahren erstellen Software, und das Ausführen der Software, wobei das Laden der Software das Laden der ersten Applikation in den FPGA und das Laden der zweiten Applikation in den Prozessor umfasst. Entsprechend können zwei Applikationen, eine auf dem Prozessor und eine auf dem FPGA, in der Hardware-Komponente abgearbeitet werden, die je nach Anwendung die I/O-Kanäle beliebig auf die beiden Applikationen aufteilen. Dies ermöglicht die Bereitstellung einer Kombination von klassischen Steuer-, Mess- oder Regelmodellen mit modellbasiert erstellten FPGA Modellen, die auf Grund der FPGA Technologie geringe Zykluszeiten im Sub-Mikrosekunden Bereich für Regelmodelle oder sehr leistungsstarke Signalvorverarbeitung für Mess-Anwendungen ermöglichen auf einer Hardware-Komponente.

In vorteilhafter Ausgestaltung der Erfindung umfasst das Verfahren den Schritt partielles Re-Konfigurieren des FPGA. Insbesondere bei der Modifikation der Applikationen kann ausgehende von dem auf dem FPGA befindlichen Code nur ein Teil ersetzt werden, wodurch das FPGA schnell mit dem modifizierten Code verwendet werden kann. Auch wird dadurch die Zeit von einem Applikationsmodell bis zur Erstellung der ersten Applikation verkürzt, da entsprechend nur Teile des FPGA-Codes implementiert werden müssen. Prinzipiell kann die Rekonfiguration beliebige Teile des FPGA-Code betreffen, also auch vorsynthetisierten Code. Entsprechend können einzelne Bestandteile vorimplementiert auf das FPGA geschrieben werden oder nach einer vorhergehenden Verwendung dort verbleiben.

Ferner betrifft die Erfindung eine Hardware-Komponente eines Mess-, Steuer- oder Regelsystems mit einem Prozessor, einem FPGA und einer Mehrzahl von I/O-Kanälen, wobei die I/O-Kanäle an das FPGA angeschlossen sind und das FPGA über ein Kommunikations-Interface mit dem Prozessor verbunden ist, wobei die Hardware-Komponente zur Durchführung des obigen Verfahrens ausgeführt ist.

Ebenfalls betrifft die Erfindung ein Computerprogrammprodukt mit Computer-implementierten Anweisungen, das nach dem Laden und Ausführen in einer geeigneten Datenverarbeitungseinrichtung das obige Verfahren ausführt.

Weiterhin betrifft die Erfindung ein digitales Speichermedium mit elektronisch auslesbaren Steuersignalen, die so mit einer programmierbaren Datenverarbeitungseinrichtung zusammenwirken können, dass das obige Verfahren auf der Datenverarbeitungseinrichtung ausgeführt wird.

Nachfolgend wird die Erfindung unter Bezugnahme auf die anliegende Zeichnung anhand bevorzugter Ausführungsformen näher erläutert.

Es zeigen
- Fig. 1: eine schematische Darstellung einer Hardware-Komponente gemäß einer Ausführungsform der Erfindung,
- Fig. 2: eine schematische Darstellung der Hardware-Komponente gemäß Fig. 1 zusammen mit einer schematischen Darstellung einer Datenverarbeitungseinrichtung zur Durchführung eines Verfahrens gemäß einer Ausführungsform der Erfindung,
- Fig. 3: ein Ablaufdiagramm eines Verfahrens gemäß einer Ausführungsform der Erfindung,
- Fig. 4: ein detailliertes Ablaufdiagramm des Schritts S2 gemäß Figur 3,
- Fig. 5: ein detailliertes Ablaufdiagramm des Schritts S23 gemäß Figur 4,
- Fig. 6: ein detailliertes Ablaufdiagramm des Schritts S3 gemäß Figur 3,
- Fig. 7: ein detailliertes Ablaufdiagramm des Schritts S4 gemäß Figur 3.

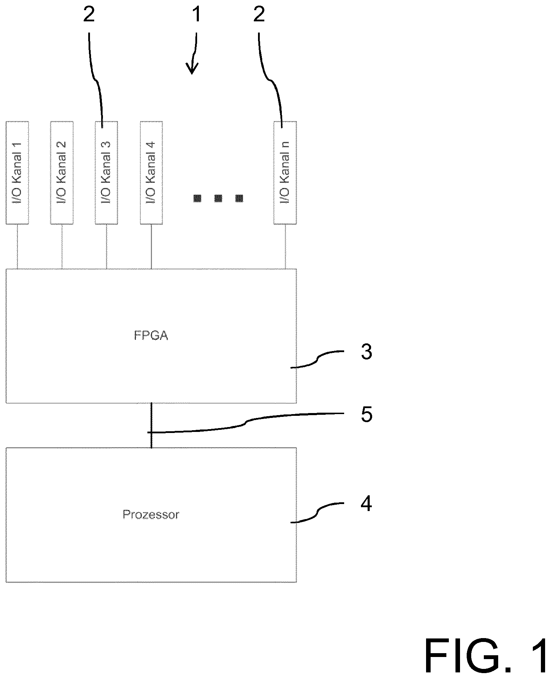

Figur 1 zeigt eine Hardware-Komponente 1 eines Mess-, Steuer- oder Regelsystems gemäß einer ersten Ausführungsform. Die Hardware-Komponente 1 ist hier beispielhaft ein Gerät für das Rapid Control Prototyping (RCP) und umfasst eine Mehrzahl von I/O-Kanälen 2, ein FPGA 3 und einen Prozessor 4. Die I/O-Kanäle 2 sind an das FPGA 3 angeschlossen und das FPGA 3 ist über ein Kommunikations-Interface 5 mit dem Prozessor 4 verbunden. In diesem Ausführungsbeispiel weist die Hardware-Komponente 1 als I/O-Kanäle 2 insgesamt 24 ADCs, 16 DACs und 48 x DIO auf, die nur teilweise in Fig. 1 dargestellt sind.

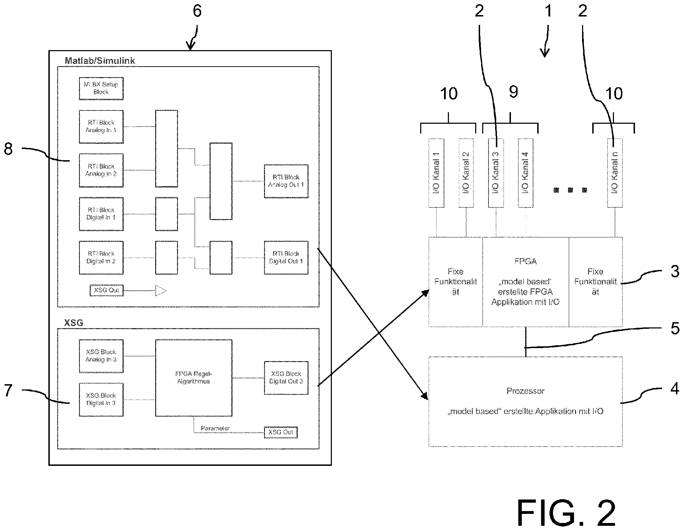

Figur 2 zeigt zusätzlich zu der Hardware-Komponente 1 eine Datenverarbeitungseinrichtung 6, die ein leistungsfähiger Computer ist. Auf der Datenverarbeitungseinrichtung 6 werden als erster Softwareblock 7 ein FPGA Programming Blockset mit einem Simulink Blockset zum Programmieren des FPGA 3 und Xilinx Tools (ISE, XSG) zum Erstellen einer ersten Applikation zur Ausführung auf dem FPGA 3 sowie als zweiter Softwareblock 8 ein RTI Blockset bzw. ein Simulink Blockset zum Erstellen einer zweiten Applikation zur Ausführung auf dem Prozessor 4 ausgeführt.

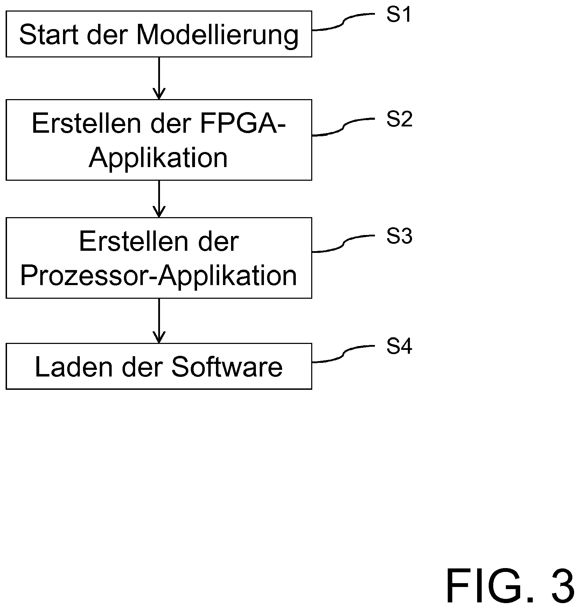

Figur 3 illustriert allgemein ein Verfahren zum Erstellen einer Software für die Hardware-Komponente 1 und zum Betreiben der Hardware-Komponente 1. Das Verfahren beginnt in Schritt S1 damit, dass ein Anwender eine Modellierung seiner Applikation, d.h. der Software für Hardware-Komponente 1, startet.

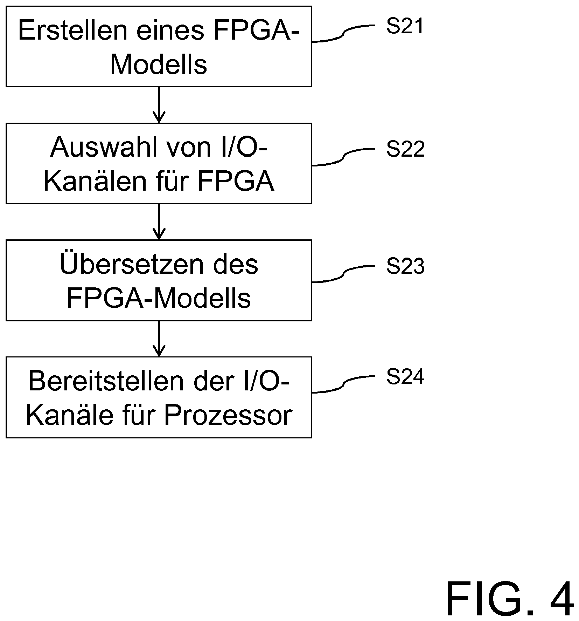

In Schritt S2 wird eine erste Applikation zur Ausführung auf dem FPGA 3 erstellt. Dazu wird zunächst, wie im Detail in Fig. 4 gezeigt ist, in Schritt S21 ein FPGA-Modell erstellt. Es werden Funktionsblöcke des XSG genutzt, um die gewünschte Funktionalität im FPGA 3 modellbasiert in Matlab/Simulink zu erstellen. Dazu werden dem Anwender von dem FPGA Programming Blockset alle I/O Kanäle 2 der Hardware-Komponente 1 zur Verfügung gestellt.

In Schritt S22 erfolgt von dem Anwender eine Auswahl einer ersten Teilmenge 9 der I/O-Kanäle 2 zur Bedienung durch das FPGA 3, d.h. eine Auswahl der I/O-Kanäle 2, die mit der ersten Applikation verbunden sind. Dazu zieht der Anwender die benötigten I/O Kanäle 2 aus dem FPGA Programming Blockset in sein FPGA Modell und verbindet diese dann mit seiner zuvor erstellten Funktionalität. Beispielsweise werden hier 8 ADCs und 8 DACs im FPGA Modell verwendet, welche die erste Teilmenge 9 bilden, wovon nur ein Teil in Fig. 2 dargestellt ist. In diesem Ausführungsbeispiel erfolgt eine automatische Auswahl einer zweiten Teilmenge 10 der I/O-Kanäle 2 zur Bedienung durch den Prozessor 4 als die Menge der I/O-Kanäle 2, die nicht zu der ersten Teilmenge 9 gehören.

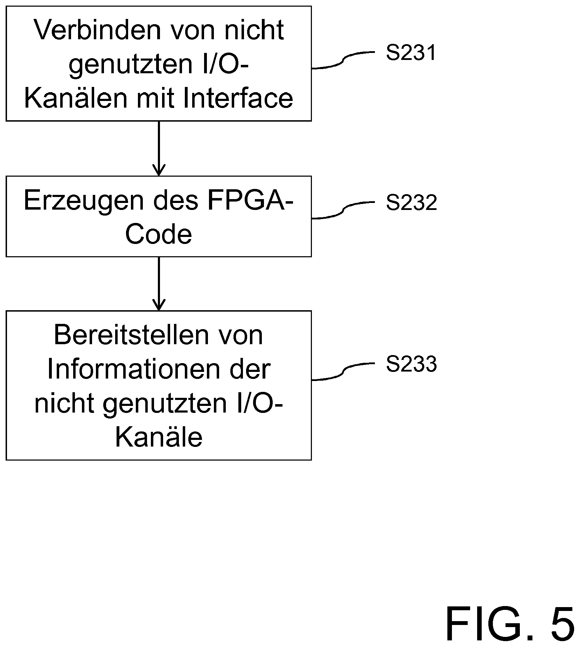

In Schritt S23 wird das FPGA Modell übersetzt. Dazu werden, wie im Detail in Fig. 5 gezeigt ist, in Schritt S231 die I/O Kanäle 2, die nicht vom FPGA Modell verwendet werden, in diesem Beispiel 16 ADCs, 8 DACs und 24 DIOs, vom FPGA Programming Blockset automatisch mit einer Standard Funktionalität belegt, so dass diese I/O-Kanäle 2 später vom RTI Blockset zur Erstellung der zweiten Applikation verwendet werden können, wie weiter unten erläutert wird.

In Schritt S232 wird der FPGA Code erzeugt. Dies umfasst das modellbasierte automatische Erstellen des Codes zu dem von dem Anwender erstellten FPGA-Modell sowie das Erstellen von Code zum Verbinden der zweiten Teilmenge 10 der I/O-Kanäle 2 mit dem Kommunikations-Interface 5. Der Code zum Verbinden der zweiten Teilmenge 10 der I/O-Kanäle 2 mit dem Kommunikations-Interface 5 beinhaltet vorsynthetisierten Code zum Verbinden der I/O-Kanäle 2 der zweiten Teilmenge 10 von I/O-Kanälen 2, der aus einer Bibliothek zu dem weiteren synthetisierten Code hinzugefügt wird. Das Verbinden von verschiedenen Bestandteilen des gesamten Codes wird beispielsweise bei FPGAs von Altera als "Fitten" und bei FPGAs von Xilinx als "MAP+Place&Route"bezeichnet.

In Schritt S233 werden Identifikationsinformationen der ersten Teilmenge 9 bereitgestellt. Die Identifikationsinformationen beinhalten Informationen, auf welchen I/O-Kanälen 2 die Standard Funktionalität zur Verfügung steht.

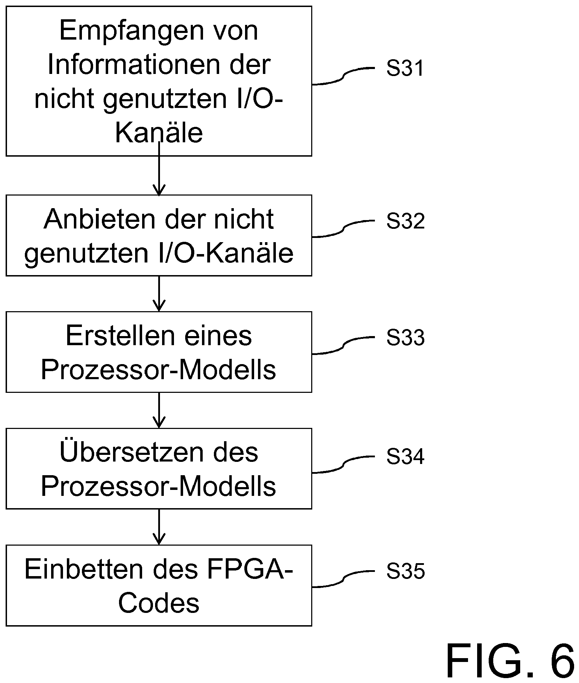

Es folgt in Schritt S3 das Erstellen der zweiten Applikation zur Ausführung auf dem Prozessor 4. Dazu erhält im Detail, wie in Fig. 6 im Detail gezeigt ist, in Schritt S31 das RTI Blockset vom FPGA Blockset die Identifikationsinformationen, welche I/O-Kanäle 2 mit der Standard Funktionalität zur Verfügung stehen. Diese werden in Schritt S32 zur Verwendung angeboten.

In Schritt S33 wird ein Applikationsmodell erstellt. Dies erfolgt in dem RTI Blockset mit den in Schritt S32 zur Verwendung angebotenen I/O-Kanälen 2. Das Modell der zweiten Applikation wird in Matlab/Simulink erstellt.

In Schritt S34 wird das fertig modellierte Modell der zweiten Applikation wie gewohnt übersetzt, d.h. es wird ein Build durchgeführt, wodurch die zweite Applikation automatisch basierend auf dem Modell erstellt wird. Dazu werden die Identifikationsinformationen der ersten Teilmenge 9 empfangen.

In Schritt S35 wird die zuvor erstellte erste Applikation, d.h. die FPGA-Applikation, in die zweite Applikation, d.h. die Prozessor Applikation, eingebettet.

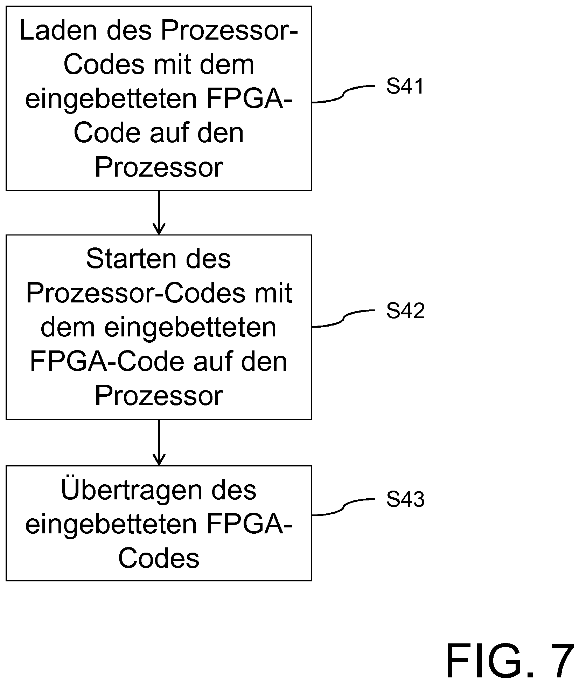

In Schritt 4 wird die erstellte Software, d.h. die erste und die zweite Applikation, auf die Hardware-Komponente geladen. Dazu wird zunächst, wie im Detail in Fig. 7 dargestellt ist, in Schritt S41 die zweite Applikation mit der eingebetteten ersten Applikation auf den Prozessor 4 geladen, wobei die zweite Applikation auf einem dem Prozessor 4 zugeordneten Speicher abgelegt wird.

In Schritt S42 wird die zweite Applikation mit der eingebetteten ersten Applikation aus dem Speicher zu Ausführung auf dem Prozessor 4 gestartet.

Durch das Ausführen der zweiten Applikation mit der eingebetteten ersten Applikation wird in Schritt S43 die erste Applikation auf das FPGA übertragen.

Anschließend kann die Hardware-Komponente 1 gemäß der geladenen ersten und zweiten Applikation betrieben werden.

## Patentansprüche

1. Verfahren zum Betreiben einer Hardware-Komponente (1) eines Mess-, Steuer- oder Regelsystems mit einem Prozessor (4), einem FPGA (3) und einer Mehrzahl von I/O-Kanälen (2), wobei die I/O-Kanäle (2) an das FPGA (3) angeschlossen sind und das FPGA (3) über ein Kommunikations-Interface (5) mit dem Prozessor verbunden ist, umfassend
das Erstellen einer Software,
das Laden der Software, und
das Ausführen der Software, wobei
das Laden der Software das Laden einer ersten Applikation in den FPGA (3) und das Laden einer zweiten Applikation in den Prozessor (4) umfasst, **dadurch gekennzeichnet, dass**
durch das Ausführen der zweiten Applikation die erste Applikation auf das FPGA übertragen wird, wobei
die Erstellung der Software die folgenden Schritte umfasst Auswahl einer ersten Teilmenge (9) der I/O-Kanäle (2) zur Bedienung durch das FPGA (3),
Erstellen der ersten Applikation zur Ausführung auf dem FPGA (3),
Auswahl einer zweiten Teilmenge (10) der I/O-Kanäle zur Bedienung durch den Prozessor (4),
Erstellen der zweiten Applikation zur Ausführung auf dem Prozessor (4), wobei
der Schritt des Erstellens der ersten Applikation das Erstellen von Code zum Verbinden der zweiten Teilmenge (10) der I/O-Kanäle (2) mit dem Kommunikations-Interface (5) umfasst, zusätzlich umfassend den Schritt
Erstellen eines Applikationsmodells, wobei
der Schritt des Erstellens der ersten Applikation das modellbasierte automatische Erstellen von Code umfasst, wobei der Schritt des Erstellens von Code zum Verbinden der zweiten Teilmenge (10) der I/O-Kanäle (2) mit dem Kommunikations-Interface (5) das automatische Erstellen von Code zum Verbinden von I/O-Kanälen (2), die Teil der zweiten Teilmenge (10) von I/O-Kanälen (2) sind, umfasst wobei
der Schritt des Erstellens der ersten Applikation das Bereitstellen von Identifikationsinformationen von I/O-Kanälen (2) der ersten Teilmenge (9) umfasst, wobei
der Schritt des Erstellens der zweiten Applikation das modellbasierte automatische Erstellen von Code umfasst wobei
der Schritt des Erstellens der zweiten Applikation das Empfangen von Identifikationsinformationen von I/O-Kanälen (2) der ersten Teilmenge (9) umfasst.

2. Verfahren nach Anspruch 1, wobei
der Schritt des Erstellens von Code zum Verbinden der zweiten Teilmenge (10) der I/O-Kanäle (2) mit dem Kommunikations-Interface (5) das Erstellen von Code zum Durchführen einer Signalverarbeitung zwischen wenigstens einem der I/O-Kanäle (2) der zweiten Teilmenge (10) und dem Kommunikations-Interface (5) umfasst.

3. Verfahren nach einem der vorhergehenden Ansprüche, wobei
der Schritt des Erstellens von Code zum Verbinden der zweiten Teilmenge (10) der I/O-Kanäle (2) mit dem Kommunikations-Interface (5) das Bereitstellen von vorsynthetisiertem Code zum Verbinden von I/O-Kanälen (2), die Teil der zweiten Teilmenge (10) von I/O-Kanälen (2) sind, umfasst.

4. Verfahren nach einem der vorhergehenden Ansprüche, wobei
wobei der Schritt des Erstellens der ersten Applikation das Empfangen von Identifikationsinformationen von I/O-Kanälen (2) der zweiten Teilmenge (10) umfasst.

5. Verfahren nach einem der vorhergehenden Ansprüche , wobei
der Schritt des Erstellens der zweiten Applikation das Bereitstellen von Identifikationsinformationen von I/O-Kanälen (2)der zweiten Teilmenge (10) umfasst.

6. Verfahren nach einem der vorhergehenden Ansprüche, zusätzlich umfassend den Schritt
partielles Re-Konfigurieren des FPGA (3).

7. Hardware-Komponente (1) eines Mess-, Steuer- oder Regelsystems mit einem Prozessor (4), einem FPGA (3) und einer Mehrzahl von I/O-Kanälen (2), wobei die I/O-Kanäle (2) an das FPGA (3) angeschlossen sind und das FPGA (3) über ein Kommunikations-Interface (5) mit dem Prozessor (4) verbunden ist, wobei
die Hardware-Komponente (1) zur Durchführung des Verfahrens nach einem der vorhergehenden Ansprüche ausgeführt ist.

## Claims

1. A method for operating a hardware component (1) of a measurement, control, or regulating system having a processor (4), an FPGA (3), and a plurality of I/O channels (2), the I/O channels (2) being connected to the FPGA (3), and the FPGA (3) being connected to the processor by means of a communications interface (5), comprising creating a software program, loading the software program, and executing the software program,
the loading of the software comprising loading a first application into the FPGA (3) and loading a second application into the processor (4), **characterized in that**
the first application is transferred to the FPGA by executing the second application, wherein
creating the software program comprises the following steps
Selecting a first subset (9) of the I/O channels (2) for operating by means of the FPGA (3),
Creating a first application for executing on the FPGA (3),
Selecting a second subset (10) of the I/O channels for operating by means of the processor (4),
Creating the second application for executing on the processor (4), wherein
the step of creating the first application comprises creating code for connecting the second subset (10) of the I/O channels (2) to the communications interface (5), and additionally comprising the step
Creating an application model, wherein
the step of creating the first application comprises model-based automatic creating of code, wherein the step of creating code for connecting the second subset (10) of the I/O channels (2) to the communications interface (5) comprises automatically creating code for connecting I/O channels (2) that are part of the second subset (10) of I/O channels (2), wherein
the step of creating the first application comprises providing identification information of I/O channels (2) of the first subset (9), wherein the step of creating the second application comprises model-based, automatic creating of code, wherein
the step of creating the second application comprises receiving identification information of I/O channels (2) of the first subset (9).

2. The method according to Claim 1, **characterized in that**
the step of creating code for connecting the second subset (10) of the I/O channels (2) to the communications interface (5) comprises creating code for performing signal processing between at least one of the I/O channels (2) of the second subset (10) and the communications interface (5).

3. The method according to any one of the preceding claims,
**characterized in that** the step of creating code for connecting the
second subset (10) of the I/O channels (2) to the communications interface (5) comprises providing presynthesized code for connecting I/O channels (2) that are part of the second subset (10) of I/O channels (2).

4. The method according to any one of the preceding claims,
**characterized in that** the step of creating the first application
comprises receiving identification information of I/O channels (2) of the second subset (10).

5. The method according to any one of the preceding claims,
**characterized in that**
the step of creating the second application comprises providing identification information of I/O channels (2) of the second subset (10).

6. The method according to any one of the preceding claims, further comprising the step
partially reconfiguring the FPGA (3).

7. A hardware component (1) of a measurement, control, or regulating system having a processor (4), an FPGA (3), and a plurality of I/O channels (2), the I/O channels (2) being connected to the FPGA (3), and the FPGA (3) being connected to the processor (4) by means of a communications interface (5), **characterized in that**
the hardware component (1) is implemented for performing the method according to any one of the preceding claims.

## Revendications

1. Procédé pour exploiter un composant matériel (1) d'un système de mesure, de commande ou de régulation avec un processeur (4), un réseau de portes programmable sur site (FPGA) (3) et une multitude de canaux E/S (2), dans lequel les canaux E/S (2) sont raccordés au FPGA (3) et le FPGA (3) est relié avec le processeur via une interface de communication (5), comprenant
la création d'un logiciel,
le chargement du logiciel, et
l'exécution du logiciel, sachant que
le chargement du logiciel comprend le chargement d'une première application dans le FPGA (3) et le chargement d'une seconde application dans le processeur (4), **caractérisé en ce que**
par l'exécution de la seconde application, la première application est transmise sur le FPGA, sachant que
la création du logiciel comprend les étapes suivantes
sélection d'un premier sous-ensemble (9) des canaux E/S (2) pour la commande par le FPGA (3),
création de la première application pour l'exécution sur le FPGA (3),
sélection d'un second sous-ensemble (10) des canaux E/S pour la commande par le processeur (4),
création de la seconde application pour l'exécution sur le processeur (4), sachant que
l'étape de création de la première application comprend la création d'un code pour relier le second sous-ensemble (10) des canaux E/S (2) avec l'interface de communication (5), comprenant en outre l'étape
création d'un modèle d'application, sachant que
l'étape de création de la première application comprend la création d'un code automatique basée sur modèles, sachant que l'étape de création d'un code pour relier le second sous-ensemble (10) des canaux E/S (2) avec l'interface de communication (5) comprend la création automatique d'un code pour relier des canaux E/S (2) qui font partie du second sous-ensemble (10) des canaux E/S (2), sachant que
l'étape de création de la première application comprend la mise à disposition d'informations d'identification de canaux E/S (2) du premier sous-ensemble (9), sachant que
l'étape de création de la seconde application comprend la création d'un code automatique basée sur modèles, sachant que
l'étape de création de la seconde application comprend la réception d'informations d'identification de canaux E/S (2) du premier sous-ensemble (9).

2. Procédé selon la revendication 1, dans lequel l'étape de création d'un code pour relier le second sous-ensemble (10) des canaux E/S (2) avec l'interface de communication (5) comprend la création d'un code pour l'exécution d'un traitement de signal entre au moins l'un des canaux E/S (2) du second sous-ensemble (10) et l'interface de communication (5).

3. Procédé selon l'une des revendications précédentes, dans lequel l'étape de création d'un code pour relier le second sous-ensemble (10) des canaux E/S (2) avec l'interface de communication (5) comprend la mise à disposition d'un code pré-synthétisé pour relier des canaux E/S (2) qui font partie du second sous-ensemble (10) des canaux E/S (2).

4. Procédé selon l'une des revendications précédentes, dans lequel l'étape de création de la première application comprend la réception d'informations d'identification de canaux E/S (2) du second sous-ensemble (10).

5. Procédé selon l'une des revendications précédentes, dans lequel l'étape de création de la seconde application comprend la mise à disposition d'informations d'identification de canaux E/S (2) du second sous-ensemble (10).

6. Procédé selon l'une des revendications précédentes, comprenant en outre l'étape
reconfiguration partielle du FPGA (3).

7. Composant matériel (1) d'un système de mesure, de commande ou de régulation avec un processeur (4), un réseau de portes programmable sur site (FPGA) (3) et une multitude de canaux E/S (2), dans lequel les canaux E/S (2) sont raccordés au FPGA (3) et le FPGA (3) est relié avec le processeur (4) via une interface de communication (5), dans lequel
le composant matériel (1) se présente sous une forme pour exécuter le procédé selon l'une des revendications précédentes.
